# EUROPEAN PATENT SPECIFICATION

(11) **EP 3 182 428 B1**
(45) Date of publication and mention of the grant of the patent: **31.10.2018**
(21) Application number: 15200890.0
(22) Date of filing: 17.12.2015
(51) Int. Cl.: H01G 4/20, H01G 4/28, G01R 15/16

(54) **CAPACITOR, CAPACITIVE VOLTAGE SENSOR AND METHOD FOR MANUFACTURING A CAPACITOR**
KONDENSATOR, KAPAZITIVER SPANNUNGSSENSOR UND VERFAHREN ZUR HERSTELLUNG EINES KONDENSATORS
CONDENSATEUR, CAPTEUR DE TENSION CAPACITIF ET PROCÉDÉ DE FABRICATION D'UN CONDENSATEUR

(43) Date of publication of application: 21.06.2017
(73) Proprietor: 3M Innovative Properties Company, St. Paul, MN 55133-3427 (US)
(72) Inventor: Stollwerck, Gunther, Dr., 47802 Krefeld (DE); Gravermann, Mark, 41812 Erkelenz (DE); Weichold, Jens, 41812 Erkelenz (DE); Sabo, Andreea, 40549 Düsseldorf (DE)
(74) Representative: Bergen, Katja

(56) References cited:
- EP-A1- 2 818 881
- GB-A- 598 817
- US-A- 3 049 651
- US-A- 3 238 428
- US-A1- 2006 125 048
- US-A1- 2013 220 666
- US-A1- 2014 296 387
- US-A1- 2014 354 302
- OHKI Y ET AL: "Analyses of various insulating polymers by broadband dielectric spectroscopy", 2014 IEEE CONFERENCE ON ELECTRICAL INSULATION AND DIELECTRIC PHENOMENA (CEIDP), IEEE, 19 October 2014 (2014-10-19), pages 582-585, XP032713358, DOI: 10.1109/CEIDP.2014.6995841 [retrieved on 2014-12-22]

## Description

The present invention relates to a capacitor, a capacitive voltage sensor, and a method for manufacturing a capacitor, particularly a capacitor with improved temperature stability of the capacitance value.

Although the invention is explained and discussed in conjunction with a cylindrical capacitor, the principles of the invention may easily be transferred to other types of capacitors as well, for example spherical capacitors or parallel plate capacitors.

Measuring the voltage in high-voltage or medium-voltage conductor assemblies in power networks, such as power cables or bus bars, is a difficult task due to the relatively high voltages and currents involved. Sensors that are based on capacitive voltage dividers have been employed in the past. In such sensors, as for example disclosed in document US 4,963,819 A, a sensing capacitor and a reference circuit element having complex impedance (e.g. a resistor, an inductivity or a further capacitor) are connected in series with their electrical properties determining the dividing ratio of the voltage divider. The sensing capacitor provides for galvanic separation from the power conductor. The voltage drop across the reference circuit element is then generally proportional to the voltage level of the power conductor.

Some of the contemporary capacitive voltage sensors include a high module ethylene propylene rubber (HEPR) insulation dielectric with a flexible outer electrode mounted thereon. However, the dielectric material can on one hand expand freely with temperature, thereby causing the capacitance value of the sensing capacitor to vastly decrease with rising temperature. On the other hand, conventional dielectric materials may have an inherent negative thermal gradient of their relative permittivity, i.e. the capacitance value of the sensing capacitor decreases with rising temperature due to a decreasing relative permittivity of the dielectric material.

There have been several attempts to remedy the fluctuations of the capacitance value of the sensing capacitor of a capacitive voltage sensor and their negative impact on measuring accuracy and reliability. For example, the fluctuations of the capacitance value may be compensated for through the use of a compensating element in the measurement circuitry, such as for example an NTC thermistor. Document US 4,241,373 A for example discloses the use of a switchgear voltage sensor, a thermistor and a resistor in a compensating network to compensate for temperature induced changes in the dielectric properties of a cast epoxy of a sensing capacitor. Document US 2014/0021965 A1 discloses temperature compensation techniques in an apparatus for measuring the potential on a shielded high-voltage cable in medium-voltage distribution networks. Document EP 2 508 898 A1 discloses a capacitive sensor arrangement on a cable employing temperature correction techniques through direct measurement of the sensor temperature and appropriate measurement signal correction or addition of a temperature-dependent element correcting temperature induced deviations in the measurement signal.

Other attempts involve capacitive medium voltage sensors including ceramic dielectrics or dielectric materials with ceramic filler particles. For example, document US 2006/0258327 A1 discloses a compensation method for compensating the thermal gradient of permittivity of a polymeric matrix with ceramic fillers having opposite thermal gradients of permittivity. Document EP 1 017 069 A2 discloses temperature compensating capacitors and dielectric ceramic powder compositions based upon a dual-component barium borate and zinc silicate sintering flux.

Further suggestions for temperature compensated capacitive voltage sensors rely on integrated reference capacitors that are subject to the same or at least similar temperature deviations of capacitance values as the sensing capacitors. For example, document WO 01/94956 A1 discloses voltage monitoring arrangements for electrical switchgear that includes a sandwich structure of a sensing electrode and a screening electrode that are spaced apart by insulating material having substantially the same temperature coefficient of relative permittivity as the insulating body of the power conductor in the electrical switchgear.

EP 2 818 881 A1 discloses a conductor assembly comprising an inner conductor, an insulating layer, a sensing electrode as well as an insulating spacer element, arranged radically between the insulating layer and the sensing electrode.

There is, however, still a need for alternative solutions for compensation of temperature induced deviations of the capacitance value of voltage sensing capacitors. Those alternative solutions may for example be more cost effective.

This need is met by a capacitor having the features of claim 1, a capacitive voltage sensor having the features of claim 14, and a method for manufacturing a capacitor having the features of claim 15.

A first aspect of the disclosure pertains to a capacitor according to claim 1 comprising an electrically conductive cylinder, an electrically conductive or semi-conductive cylindrical shell or shell segment arranged concentrically around the electrically conductive cylinder, and a dielectric arranged between the electrically conductive cylinder and the electrically conductive or semi-conductive cylindrical shell or shell segment. The dielectric comprises at least one dielectric layer having a positive thermal coefficient of relative permittivity, and at least one compensation dielectric layer having a negative thermal coefficient of relative permittivity. The dielectric layers of the dielectric are arranged between the electrically conductive cylinder and the electrically conductive cylindrical shell or shell segment. The thermal coefficients of relative permittivity are thereby selected such that the capacitance value of the capacitor is constant within a stability margin over a predefined temperature interval. According to the invention the layered arrangement of dielectric materials in the voltage sensing capacitor is selected such that the thermal gradient of relative permittivity of one of the dielectric material layers (e. g. the compensation dielectric layer) compensates any changes in relative permittivity of the other dielectric material layers with temperature and compensates any changes in capacitance value of the voltage sensing capacitor.

The stability margin or the capacitor according to the invention may for example be equal to or less than +/-3.0%, +/-0.5% or +/-0.2% of the capacitance value of the capacitor according to IEC 60044-7 (1999). The predefined temperature interval is according to IEC 60044-7 between -25°C and +40°C or between -40°C and +40°C. Depending on the desired application of the capacitor, other predefined temperature intervals may also be chosen as well, such as for example between -20°C and +60°C, or between -40°C and +70°C.

According to a second aspect of the disclosure, a capacitive voltage sensor according to claim 10 comprises a capacitor according to the first aspect of the disclosure as voltage sensing capacitor, a reference impedance coupled in series between the voltage sensing capacitor and a reference potential, and a voltage measurement circuit configured to measure a voltage drop across the reference impedance. The voltage sensing capacitor and the reference impedance may in particular implement a voltage divider circuit with a predefined dividing ratio. The voltage measurement circuit may for example comprise a voltage measurement device or an operational amplifier circuit or a remote terminal unit, which is measuring the voltage.

According to a third aspect of the disclosure, a method according to claim 11 for manufacturing a capacitor according to the first aspect of the disclosure for use in a capacitive voltage sensor according to the second aspect of the disclosure comprises the steps of applying a dielectric to an electrically conductive cylinder, and arranging an electrically conductive or semi-conductive cylindrical shell or shell segment concentrically around the electrically conductive cylinder over the dielectric. The dielectric comprises at least one dielectric layer having a positive thermal coefficient of relative permittivity and at least one compensation dielectric layer having a negative thermal coefficient of relative permittivity. Without the compensation dielectric layer, the thermal coefficient of the capacitance value of the voltage sensing capacitor is typically positive, i.e. the capacitance value increases with increasing temperature with typically and preferably chosen dielectrics. Thus, if that is the case, the material of the compensation dielectric layer may preferably be chosen to have a negative thermal coefficient of relative permittivity, i.e. the relative permittivity of the compensation dielectric layer decreases with increasing temperature.

Advantageously, the need for an external electrical compensation technique, such as for example the use of an NTC thermistor, may be obviated due to the excellent temperature stability of the capacitance value of the voltage sensing capacitor according to the invention. Furthermore, there is advantageously no need for the use of ceramic materials in the dielectric of the voltage sensing capacitor, which are usually quit expensive and difficult to manufacture. Finally, the manufacturing complexity for voltage sensing capacitor in line with this disclosure is significantly less than for capacitors with comparable thermal stability since they can be produced with standard injection moulding systems by adding a subsequent separate application of additional dielectric compensation layers.

According to some embodiments of the capacitor, the at least one compensation dielectric layer may be sandwiched between the at least one dielectric layer and the electrically conductive or semi-conductive cylindrical shell or shell segment. In some particular embodiments, the electrically conductive or semi-conductive cylindrical shell or shell segment forms a ring structure having a recessed trench extending circumferentially in its inner wall. In that regard, the at least one compensation dielectric layer may comprise a sealant embedded within the recessed trench of the electrically conductive or semi-conductive cylindrical shell or shell segment. This advantageously prevents the sealant flowing away when the temperature increases. The sealant is held tightly in place by the ring structure.

Moreover, with the use of a recessed annulus, the outer edges of the outer electrode may advantageously be shaped to minimize the strength of the electrical field in that area, for example similar to a Rogowski profile or Borda profile by constructing the electrode shapes to create approximately equipotential electrode surfaces at the edges thereof, thereby significantly reducing the risk of electric breakdown of the capacitor.

According to some other embodiments of the capacitor, the at least one compensation dielectric layer is sandwiched between the at least one dielectric layer and the electrically conductive cylinder. This may be particularly advantageous, if the dielectric layer is provided in prefabricated tube or sleeve form that needs to be pulled over the compensation dielectric layer and thereby keeps the compensation dielectric layer mechanically in place.

The electrically conductive cylinder of the invention forms part of a high-voltage or medium-voltage power conductor in a high-voltage or medium-voltage power network. The components of the capacitor may in particular be heated up due to the current flowing through current carrying conductors in such networks. Due to the large changes of temperature the materials depending on the amount of current flowing through the current carrying conductors of high-voltage or medium-voltage power network the fluctuations in dimensions and relative permittivity of the conventional parts of the capacitor are subject to large changes as well. Therefore, the compensation dielectric layer may be particularly useful for high-voltage or medium-voltage applications.

According to some embodiments of the capacitor, the electrically conductive or semi-conductive cylindrical shell or shell segment comprises a mechanically rigid metal component, in particular an aluminium, steel and/or copper annulus. The mechanically rigid metal component may reduce the thermal expansion effect of the capacitor significantly.

According to some embodiments of the capacitor, the at least one dielectric layer comprises at least one of a resin, an epoxy or a polyurethane. The polymeric material may be filled with high permittivity materials, such as for example titanate such as barium titanate or conductive carbon black powder dispersed in the polymeric materials. In some embodiments, when the at least one dielectric layer comprises an epoxy or a polyurethane, the at least one compensation dielectric layer may comprise any plastic or rubber material like for example silicone, ethylene propylene diene monomer (EPDM), high module ethylene propylene rubber (HEPR), polyethylene (PE), polypropylene (PP), particularly a cold-shrink silicone tube.

According to a disclosed aspect of the capacitive voltage sensor, parts of the circuitry, and in particular the reference impedance, may be installed on a printed circuit board (PCB). The electrical connection between the reference impedance on the PCB and the voltage sensing capacitor may be established for example by wiring to create a series connection of the voltage sensing capacitor and the reference impedance on the PCB to be used as a voltage divider.

According to some embodiments, the voltage sensing capacitor may extend wholly or only partially around the circumference of the electrically conductive cylinder. For only partially extending capacitors, i.e. capacitors with only a partial shell segment acting as electrically conductive outer electrode, it may be necessary to take additional measures for keeping the outer electrode in place relatively to the electrically conductive cylinder and for shielding the capacitor from interfering electric fields.

The capacitive voltage sensor may be integrated into cable accessory, such as for example a termination, a splice or a separable connector or a t-body, thereby arranging all elements of the sensor in a space saving and compact assembly. The capacitive voltage sensor may further comprise two or more shells or shell segments that may be brought into engagement with each other in order to form a voltage sensor having tubular shape. This may allow the capacitive voltage sensor to be installed around a current carrying conductor at a longer distance from an end of the current carrying conductor. The capacitive voltage sensor may alternatively have the electrically conductive shell integrally formed in one piece only for mounting over an end of a cable.

According to a further disclosed aspect, a contact element may serve as electrically conductive cylinder. To that end, the contact element may be arranged between a current carrying conductor running through the centre of the capacitor and the dielectric. The contact element may then be electrically connected with the current carrying conductor. This can either be done with the electrically conductive cylinder being a separate electrode element and directly contacting the current carrying conductor. Alternatively, an additional contact element may be arranged between the current carrying conductor and the electrically conductive cylinder which in both cases may be hollow to at least partially surround the contact element and the current carrying conductor.

Providing an additional contact element between the conductor and the electrically conductive cylinder may provide advantageous due to the thermal decoupling of the electrically conductive cylinder from the current carrying conductor. The capacitor may in this case have a lower temperature dependency in terms of thermal expansion, thereby guaranteeing a higher accuracy.

The contact element is ideally mechanically reliable and should withstand mechanical forces caused by relative movement of the capacitor with respect to the current carrying conductor or by different thermal expansion coefficients of the electrically conductive cylinder and the current carrying conductor. The contact element may to this end comprise a resilient portion guaranteeing a reliable and therefore low resistance contact surface between the current carrying conductor and the electrically conductive cylinder. The contact element may be resiliently supported and/or consist of resilient material. The contact element may for example comprise elastomeric material which may be electrically conductive or be coated with an electrically conductive surface coating.

The invention will be explained in greater detail with reference to exemplary embodiments depicted in the drawings as appended.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
- Fig. 1: schematically illustrates a perspective view of a voltage sensing capacitor according to an embodiment of the invention.
- Fig. 2: schematically illustrates an axial cross section view through the voltage sensing capacitor of Fig. 1 along the line B-B according to a further embodiment of the invention.
- Fig. 3: schematically illustrates a radial cross section view through the voltage sensing capacitor of Fig. 1 along the line A-A according to a further embodiment of the invention.
- Fig. 4: schematically illustrates a radial cross section view through a modified voltage sensing capacitor according to another embodiment of the invention.
- Fig. 5: schematically illustrates a radial cross section view through a modified voltage sensing capacitor according to an even further embodiment of the invention.
- Fig. 6: schematically illustrates a radial cross section view through a modified voltage sensing capacitor according to yet another embodiment of the invention.
- Fig. 7: schematically illustrates a perspective view of a sensing electrode of a voltage sensing capacitor with an embedded compensation dielectric material according to yet another embodiment of the invention.
- Fig. 8: schematically illustrates a cut-away view of the sensing electrode of Fig. 7.
- Fig. 9: shows a measurement diagram illustrating the thermal dependence of relative permittivity of a compensation dielectric layer according to yet another embodiment of the invention.
- Fig. 10: shows a measurement diagram illustrating the thermal dependence of capacitance value of a voltage sensing capacitor according to a further embodiment of the invention.
- Fig. 11: schematically illustrates a perspective view of a further voltage sensing capacitor according to a further disclosed example useful for understanding the invention.
- Fig. 12: schematically illustrates a block diagram of capacitive voltage sensor circuitry according to another embodiment of the invention.
- Fig. 13: schematically illustrates stages of a method for manufacturing a voltage sensing capacitor according to another embodiment of the invention.

In the figures, like reference numerals denote like or functionally like components, unless indicated otherwise. Any directional terminology like "top", "bottom", "left", "right", "above", "below", "horizontal", "vertical", "back", "front", and similar terms are merely used for explanatory purposes and are not intended to delimit the embodiments to the specific arrangements as shown in the drawings.

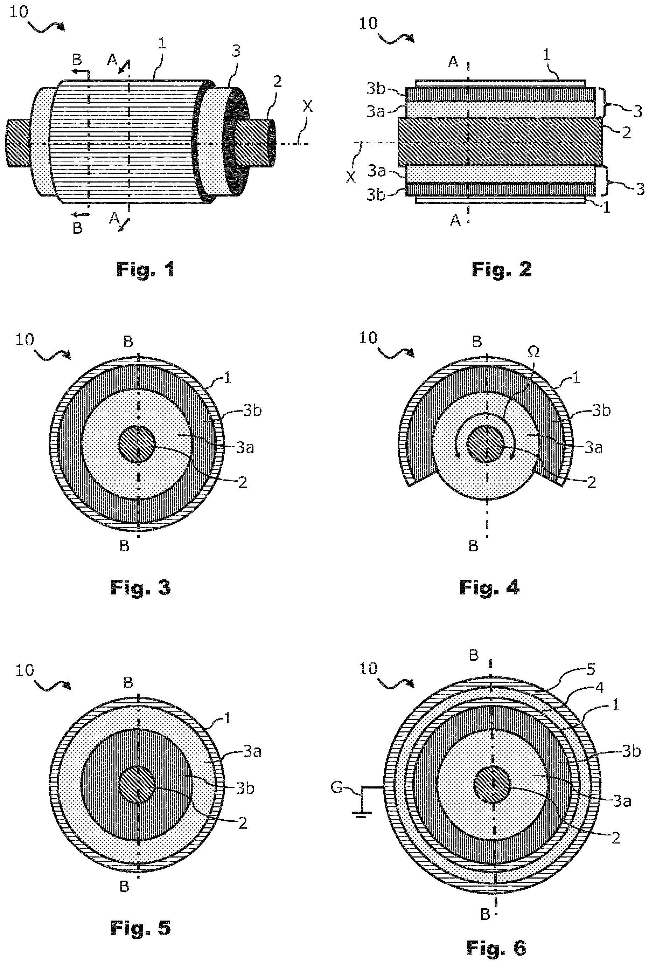

Although specific embodiments have been illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein. A perspective view of a voltage sensing capacitor 10 is schematically illustrated in Fig. 1. The two sectional view along the lines A-A and B-B of the voltage sensing capacitor 10 of Fig. 1 are shown in Figs. 2 and 3, respectively. The voltage sensing capacitor 10 is generally of cylindrical or tubular shape having a central axis denoted with the reference sign X. Of course, the cylindrical shape does not necessarily need to be straight, but instead bent or curved cylindrical shapes may be equally possible. Particularly, when used for sensing a voltage of a current carrying conductor, the voltage sensing capacitor 10 may be manufactured from generally flexible or elastic materials, allowing the capacitor 10 to be bent at its central axis X to deviate from the purely straight cylindrical shape.

Along the central axis X an electrically conductive cylinder 2 is arranged to act as an inner electrode of the capacitor 10. The electrically conductive cylinder 2 may particularly form a part of a high-voltage or medium-voltage power conductor in a high-voltage or medium-voltage power network. An electrically conductive or semi-conductive cylindrical shell 1 is arranged concentrically around the electrically conductive cylinder 2, being spaced apart from the electrically conductive cylinder 2. The electrically conductive or semi-conductive cylindrical shell 1 acts as outer electrode or counter-electrode for the inner electrode of the capacitor 10. In between the two electrodes 1 and 2, a dielectric 3 is arranged.

As can be seen in the drawings of Figs. 2 and 3, the dielectric 3 generally includes a layered arrangement of at least one dielectric layer 3a and at least one compensation dielectric layer 3b. The dielectric layer 3a and the compensation dielectric layer 3b are stacked on top of each other. Although only two layers 3a and 3b are shown in the drawings, it may also be possible to provide for multiple layers 3a and 3b alternately stacked on top of each other. It is also possible the stack several dielectric layers 3a on top of each other and follow with several compensation dielectric layers 3b. The dielectric layer(s) 3a may have a positive thermal coefficient of relative permittivity. Therefore, upon an increase in temperature, the relative permittivity of the dielectric layer(s) 3a will increase and cause the capacitance value of the capacitor 10 to rise concomitantly.

The compensation dielectric layer(s) 3b are therefore chosen to have a negative thermal coefficient of relative permittivity. The negative thermal coefficient of relative permittivity of the compensation dielectric layer(s) 3b is selected such that the capacitance value of the capacitor is constant within a stability margin over a predefined temperature interval. In other words, the negative thermal coefficient of relative permittivity of the compensation dielectric layer(s) 3b is used to compensate for the positive thermal coefficient of relative permittivity of the dielectric layer(s) 3a so that the effective relative permittivity of the dielectric 3 as a whole will remain stable with a change in temperature or will slightly change with changing temperature within the stability margins mentioned above. Another option is, that the dielectric layer(s) 3a has a negative thermal coefficient of relative permittivity and the compensation dielectric layer(s) layer 3b has a positive thermal coefficient of relative permittivity. The temperature compensation works equivalently.

The stability margin may be predefined according to quality standards of the voltage sensing capacitor when used in a capacitive voltage sensor. Some quality standards, e.g. IEC 60044-7 (1999), define a stability margin equal to or less than +/- 3.0% of the capacitance value of the capacitor 10, alternatively a stability margin equal to or less than +/- 0.5% of the capacitance value of the capacitor 10, or alternatively a stability margin equal to or less than +/- 0.2% of the capacitance value of the capacitor. The material, dimensions and positioning of the dielectric layer 3a and the compensation dielectric layer 3b may thus be selected to be able to keep the capacitance value within the desired stability margin.

The temperature interval may be equally predefined by quality standards, e.g. IEC 60044-7 (1999) or the intended application. In some applications, capacitive voltage sensors are employed in warmer regions of the earth, such as for example Northern Africa or Central America. In those regions, the temperature intervals of interest may be higher than in colder regions of the earth, such as for example Scandinavia or Canada. The predefined temperature interval may for example lie between -40°C and +70°C or between -40°C and +40°C or between -25°C and +40°C.

Figs. 4, 5 and 6 each schematically illustrate modified voltage sensing capacitors 10 in radial cross section view similar to the view in Fig. 3. The voltage sensing capacitors 10 of the Figs. 4, 5 and 6 are each modified in different details and various features with respect to the voltage sensing capacitor 10 as shown and explained in conjunction with Figs. 1, 2 and 3. Of course, the modification of the details for one of the voltage sensing capacitors 10 of the Figs. 4, 5 and 6 may equally be applied to respective other ones of the voltage sensing capacitors 10 and the modification possibilities are not limited to the ones explicitly and exemplarily depicted in those drawings.

In the exemplary arrangement of Figs. 2 and 3, the at least one compensation dielectric layer 3b is sandwiched between the at least one dielectric layer 3a and the electrically conductive or semi-conductive cylindrical shell 1 or shell segment. Of course, the stacking of the layers 3a and 3b may also be reversed as shown exemplarily in Fig. 5.

The outer electrode in Figs. 2 and 3 is depicted as closed ring structure, i.e. a shell 1 surrounding the full 360° of the circumference of the cylindrical capacitor shape. However, as exemplarily depicted in Fig. 4, it may be equally possible to use an electrically conductive or semi-conductive cylindrical shell segment 1 that only surrounds a fraction Ω of the circumference of the cylindrical capacitor shape. The fraction Ω may be chosen according to the intended application and may generally take on any value between 0° and 360°. It may further be possible to use more than one electrically conductive or semi-conductive cylindrical shell segment 1 as outer electrode so that a plurality of electrically conductive or semi-conductive cylindrical shell segments 1 may be equidistantly spaced around the circumference of the cylindrical capacitor shape.

As shown in Fig. 6, it may be possible to provide a screening electrode 5 arranged concentrically with and around the electrically conductive or semi-conductive cylindrical shell 1. The screening electrode 5 may be connected to a reference potential, for example to ground G. A further dielectric 4, for example being made of the same material as the dielectric layer 3a may be provided between the electrically conductive or semi-conductive cylindrical shell 1 and the screening electrode 5. The capacitor formed by the electrically conductive or semi-conductive cylindrical shell 1 as inner electrode, the dielectric 4 and the screening electrode 5 may also be used as reference capacitor in a series connection with the screened voltage sensing capacitor 10. That way, some of the thermal expansion effects affecting the screened voltage sensing capacitor 10 may apply equally to the reference capacitor as well, so that the dividing ratio of the voltage divider is kept approximately constant.

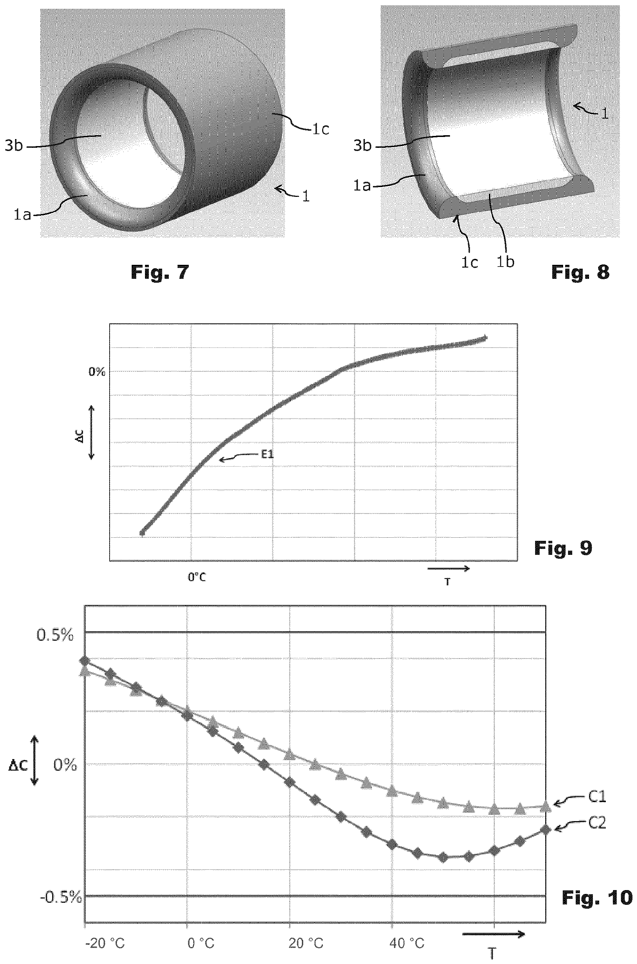

If the electrically conductive or semi-conductive cylindrical shell 1 or shell segment comprises a mechanically rigid metal component, for example an aluminium, steel and/or copper annulus, the compensation dielectric layer 3b may be implemented as embedded dielectric material in the inner wall of the rigid metal component. Figs. 7 and 8 schematically illustrate a perspective view and a cut-away view, respectively, of a sensing electrode to be used in a voltage sensing capacitor 10 of one of the Figs. 1 to 6. The sensing electrode is formed as an electrically conductive or semi-conductive cylindrical shell 1 shaped in ring form having an outer wall 1c and a recessed trench 1b extending circumferentially in its inner wall. The recessed trench 1b is bordered by an edge portion 1a of the ring structure that prevents the material from flowing out of the trench 1b. The compensation dielectric layer 3b may be implemented as mastic or sealant or silicone that is embedded within the recessed trench 1b of the electrically conductive or semi-conductive cylindrical shell 1 or shell segment.

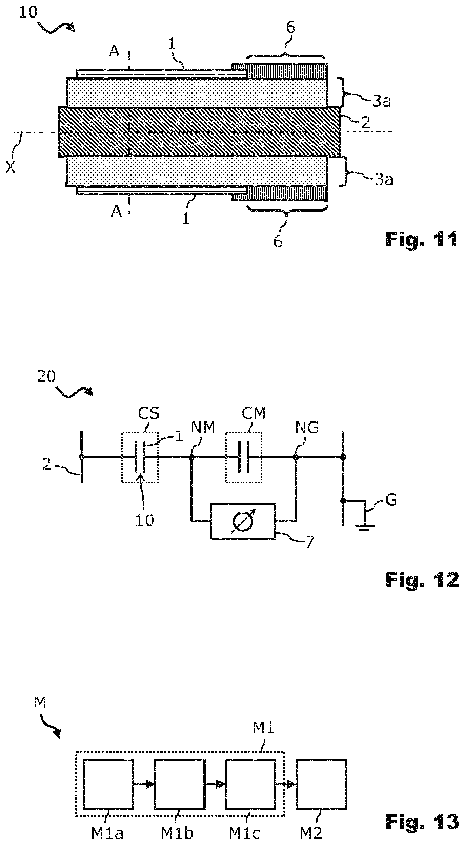

Fig. 11 schematically illustrates another example useful for understanding the invention. The capacitor 10 of Fig. 11 further includes a stress control material 6 that is applied to the dielectric 3 adjoining to the electrically conductive or semi-conductive cylindrical shell 1 or shell segment. The stress control material 6 may form a layer on top of the dielectric 3 that at least partially reaches over the electrically conductive or semi-conductive cylindrical shell 1. It is also possible to arrange the stress control material 6 adjacent to the shell 1. The stress control material 6 replaces the dielectric compensation layer 3b. Depending on the thermal coefficient of relative permittivity of the dielectric layer 3a, the stress control material 6 may comprise a material having the opposite thermal coefficient of relative permittivity than layer 3a. For example the dielectric layer 3a may have a positive thermal coefficient of relative permittivity and the stress control material 6 may comprise a negative thermal coefficient of relative permittivity.

The electrical stray field extends outside of the area defined between the electrically conductive or semi-conductive cylindrical shell 1 and the electrically conductive cylinder 2, so that a stress control material 6 adjoining the electrically conductive or semi-conductive cylindrical shell 1 lies at least partially within this stray field. With a positive thermal coefficient of relative permittivity, the stress control material 6 may aid in compensating for the negative thermal coefficient of relative permittivity of the dielectric layer 3a and vice versa. Since stress control may be needed anyway, the additional relative permittivity compensation may be added without additional manufacturing steps. To that end, the length of the material may be selected so that the amount of relative permittivity compensation keeps the capacitance value of the capacitor 10 overall within the predefined stability margins.

The dielectric layer 3a may for example comprise a resin, such as an epoxy and/or polyurethane. It may also be filled with high permittivity materials, such as for example titanate such as barium titanate or conductive carbon black powder dispersed in the polymeric material If the compensation dielectric layer 3a comprises a resin, an epoxy or a polyurethane resin, the compensation dielectric layer 3b may comprise a rubber material like for example silicone, ethylene propylene diene monomer (EPDM), high module ethylene propylene rubber (HEPR), Polyethylene (PE), Polypropylene (PP), particularly a cold-shrink silicone tube..

Fig. 9 shows a measurement diagram illustrating the thermal dependence E1 of capacitance value of a compensation dielectric layer 3b including barium titanate (BaTiO₃) particles dispersed in polymeric material. As can be seen, the compensation dielectric layer 3b has a relative permittivity increasing with temperature. Such a compensation dielectric layer 3b may be used for forming a stress control material 6 of Fig. 11 as well.

Fig. 10 shows a measurement diagram illustrating the thermal dependence C1, C2 of capacitance value C of a voltage sensing capacitor 10 for various combinations of materials of the dielectric layer 3a and the compensation dielectric layer 3b. The measurement curve C1 depicts the capacitance value C vs temperature for a 6.5 mm dielectric layer 3a consisting of the epoxy Scotchcast® Electrical Resin 250 available from 3M, U.S.A filled with 45vol% quartz-sand powder, in combination with a 2 mm compensation dielectric layer 3b consisting of a track-resistant silicone tube available from 3M, U.S.A. The measurement curve C2 depicts the capacitance value C vs temperature for a 7 mm dielectric layer 3a consisting of the epoxy Scotchcast® Electrical Resin 250 available from 3M, U.S.A. mixed with 15vol% glass bubbles IM16K available from 3M, U.S.A. in combination with a 3.5 mm compensation dielectric layer 3b consisting of Elastosil® 4305/40 silicone available from Wacker Chemie, Germany. As can be seen, the relative deviation ΔC from a reference capacitance value for each of the combinations does not exceed ±0.5% over temperature interval of at least -20°C to +70°C.

Typical axial lengths of the cylindrical capacitors 10 are around at least 20mm to 500mm preferably between 30 - 60 mm. Any other length is possible as well and strongly depends on the application.

Instead of epoxy, a polyurethane resins such as for example Scotchcast® Flame-Retardant Compound 2131 available from 3M, U.S.A. may be selected for the dielectric layer 3a as well. In particular, materials having high shore hardness may be advantageously chosen to largely avoid thermal expansion problems.

Fig. 12 schematically illustrates a block diagram of capacitive voltage sensor circuitry 20 employing a capacitor 10 as a voltage sensing capacitor CS of a voltage divider. A reference impedance, such as for example a reference capacitor CM, is coupled in series between the voltage sensing capacitor CS and a reference potential such as for example ground G. A voltage measurement circuit 7 that is connected to a node NM between the two capacitors CS and CM on one hand and to a node NG connected to the reference potential on the other hand is configured to measure a voltage drop across the reference capacitor CM. The measured voltage drop may then be output to a control processor that produces a corresponding voltage signal. The control processor may for example be additionally equipped with electronic compensation means that further enhance the accuracy of the voltage signal, for example by taking into account temperature induced variations of the electric properties of the capacitors CS and CM. The reference capacitor CM may for example be installed on a PCB in the vicinity of the voltage sensing capacitor CS to provide for a compact voltage sensor assembly 20.

Fig. 13 schematically illustrates stages of a method M for manufacturing a capacitor, for example a voltage sensing capacitor 10 as explained in conjunction with Figs. 1 to 8. The method M may be specifically used for manufacturing a capacitor that may be used as voltage sensing capacitor CS in a capacitive voltage sensor assembly 20 as illustrated in conjunction with Fig. 12.

In a first step M1, a dielectric 3 is applied to an electrically conductive cylinder 2. The dielectric is comprised of at least one dielectric layer 3a having a positive thermal coefficient of relative permittivity and at least one compensation dielectric layer 3b having a negative thermal coefficient of relative permittivity. The application in step M1 may for example be performed by first moulding a dielectric layer 3a, e.g. an epoxy layer, over the electrically conductive cylinder 2 in a sub stage M1a. Then, in a following optional sub-stage M1b, the epoxy of the dielectric layer 3a may be cross-linked at a predefined cross-linking temperature and post-cured at a predefined post-curing temperature.

After moulding the epoxy layer, cooling the epoxy and removing the epoxy from the mould, a compensation dielectric layer 3b may be cast on top of the epoxy. For example, a silicone tube may be used as compensation dielectric layer 3b. The application of the compensation dielectric layer 3b may in particular involve a sub stage M1c, cold-shrink tubing the silicone tube over the moulded epoxy layer. Cold-shrink tubing involves sliding a rubber sleeve, made for example from elastomeric silicone and pre-stretched over a removable support tube, over the component onto which the sleeve shall be installed and retracting the removable support tube to cause the sleeve to contract tightly over the underlying component.

Then, in a stage M2, an electrically conductive or semi-conductive cylindrical shell 1 or shell segment is arranged concentrically around the electrically conductive cylinder 2 over the dielectric 3. This may for example be done by applying an electrically conductive ink or coating on the compensation dielectric layer 3b, or, alternatively, cold-shrink tubing an electrically conductive tube, for example made from silicone, on the compensation dielectric layer 3b. For electrically contacting the electrically conductive or semi-conductive cylindrical shell 1 or shell segment a copper tape may be applied on top of the electrode.

In the foregoing detailed description, various features are grouped together in one or more examples or examples with the purpose of streamlining the disclosure. It is to be understood that the above description is intended to be illustrative, and not restrictive. It is intended to cover all alternatives, modifications and equivalents. Many other examples will be apparent to one skilled in the art upon reviewing the above specification.

The embodiments were chosen and described in order to best explain the principles of the invention and its practical applications, to thereby enable others skilled in the art to best utilize the invention and various embodiments with various modifications as are suited to the particular use contemplated. In the appended claims and throughout the specification, the terms "including" and "in which" are used as the plain-English equivalents of the respective terms "comprising" and "wherein," respectively. Furthermore, "a" or "one" does not exclude a plurality in the present case.

## Claims

1. Capacitor (10) for use in a high-voltage or medium-voltage sensor, comprising:
an electrically conductive cylinder (2) which forms part of a high-voltage or medium-voltage power conductor in a high-voltage ore medium-voltage power network;
an electrically conductive or semi-conductive cylindrical shell (1) or shell segment arranged concentrically around the electrically conductive cylinder (2); and
a dielectric (3),
the dielectric (3) comprising:
at least one dielectric layer (3a) having a positive thermal coefficient of relative permittivity; and
at least one compensation dielectric layer (3b) having a negative thermal coefficient of relative permittivity,
wherein the dielectric layers (3a or 3b, 6) are arranged between the electrically conductive cylinder (2) and the electrically conductive or semi-conductive cylindrical shell (1) or shell segment
**characterized in that** the at least one compensation dielectric layer (3b) is chosen in such a way that it compensates for any changes in relative permittivity of the at least one other dielectric layer with temperature and therewith compensates any changes in capacitance value of the voltage sensor.

2. Capacitor (10) according to claim 1, wherein the at least one compensation dielectric layer (3b) is sandwiched between the at least one dielectric layer (3a) and the electrically conductive or semi-conductive cylindrical shell (1) or shell segment.

3. Capacitor (10) according to claim 1 or 2, wherein the electrically conductive or semi-conductive cylindrical shell (1) or shell segment forms a ring structure having a recessed trench (1b) extending circumferentially in its inner wall.

4. Capacitor (10) according to claim 3, wherein the at least one compensation dielectric layer (3b) comprises a sealant embedded within the recessed trench (1b) of the electrically conductive or semi-conductive cylindrical shell (1) or shell segment.

5. Capacitor (10) according to claim 1, wherein the at least one compensation dielectric layer (3b) is sandwiched between the at least one dielectric layer (3a) and the electrically conductive cylinder (2).

6. Capacitor (10) according to one of the preceding claims, wherein the electrically conductive or semi-conductive cylindrical shell (1) or shell segment comprises a mechanically rigid metal component, in particular an aluminium, steel and/or copper annulus.

7. Capacitor (10) according to one of the preceding claims, wherein the at least one dielectric layer (3a) comprises a resin, selected from epoxy and polyurethane.

8. Capacitor (10) according to one of the preceding claims, wherein the at least one dielectric layer (3a) is filled with high permittivity materials, such as for example titanate such as barium titanate or conductive carbon black powder dispersed in the polymeric material.

9. Capacitor (10) according to one of the preceding claims, wherein the at least one compensation dielectric layer (3b) comprises plastic or rubber material like for example silicone, ethylene propylene diene monomer (EPDM), high module ethylene propylene rubber (HEPR), polyethylene (PE) and/or polypropylene (PP).

10. Capacitive voltage sensor (20), comprising:
a capacitor (10) according to one of the preceding claims as voltage sensing capacitor (CS);
a reference impedance (CM) coupled in series between the voltage sensing capacitor (CS) and a reference potential (G); and
a voltage measurement circuit configured to measure a voltage drop across the reference impedance (CM).

11. Method (M) for manufacturing a capacitor (10) for use in a high-voltage or medium-voltage sensor, comprising:
an electrically conductive cylinder (2) which forms part of a high-voltage or medium-voltage power conductor in a high-voltage ore medium-voltage power network;
an electrically conductive or semi-conductive cylindrical shell (1) or shell segment arranged concentrically around the electrically conductive cylinder (2); and
a dielectric (3),
the dielectric (3) comprising:
at least one dielectric layer (3a) having a positive thermal coefficient of relative permittivity; and
at least one compensation dielectric layer (3b) having a negative thermal coefficient of relative permittivity,
wherein the dielectric layers (3a or 3b, 6) are arranged between the electrically conductive cylinder (2) and the electrically conductive or semi-conductive cylindrical shell (1) or shell segment
and wherein the at least one compensation dielectric layer (3b) is chosen in such a way that it compensates for any changes in relative permittivity of the at least one other dielectric layer with temperatures and therewith compensates any changes in capacitance value of the voltage sensor, comprising the steps of:
- applying (M1) a dielectric (3) to an electrically conductive cylinder (2) that forms part of a high-voltage or medium-voltage power conductor in a high-voltage or medium-voltage power network; and
- arranging (M2) an electrically conductive or semi-conductive cylindrical shell (1) or shell segment concentrically around the electrically conductive cylinder (2) over the dielectric (3),
wherein the dielectric (3) comprises at least one dielectric layer (3a) having a positive thermal coefficient of relative permittivity and at least one compensation dielectric layer (3b) having a negative thermal coefficient of relative permittivity.

12. Method (M) according to claim 11, wherein applying (M1) the dielectric (3) comprises:
- moulding (M1a) a dielectric layer (3a) over the electrically conductive cylinder (2); and
- applying (M1c) a compensation dielectric layer (3b) over the moulded dielectric layer.

13. Method (M) according to one of the claims 11 or12, wherein arranging (M2) the electrically conductive or semi-conductive cylindrical shell (1) or shell segment comprises:
- applying an electrically conductive ink or coating on the dielectric layer (3a); or
- cold-shrink tubing an electrically conductive tube on the dielectric layer (3a).

## Patentansprüche

1. Kondensator (10) zur Verwendung in einem Hochspannungs- oder Mittelspannungssensor, umfassend:
einen elektrisch leitenden Zylinder (2), der einen Bestandteil eines Hochspannungs- oder Mittelspannungsstromleiters in einem Hochspannungs- oder Mittelspannungsstromnetz bildet;
eine elektrisch leitende oder halbleitende zylindrischen Schale (1) oder ein Schalensegment, konzentrisch um den elektrisch leitenden Zylinder (2) angeordnet; und
ein Dielektrikum (3),
wobei das Dielektrikum (3) Folgendes umfasst:
mindestens eine dielektrische Schicht (3a), die einen positiven thermischen Koeffizienten relativer Permittivität aufweist; und
mindestens eine dielektrische Kompensationsschicht (3b), die einen negativen thermischen Koeffizienten relativer Permittivität aufweist,
wobei die dielektrischen Schichten (3a oder 3b, 6) zwischen dem elektrisch leitenden Zylinder (2) und der elektrisch leitenden oder halbleitenden zylindrischen Schale (1) oder dem Schalensegment angeordnet sind, **dadurch gekennzeichnet, dass** die mindestens eine dielektrische Kompensationsschicht (3b) so gewählt ist, dass sie jegliche Änderungen der relativen Permittivität der mindestens einen anderen dielektrischen Schicht mit Temperatur kompensiert und damit jegliche Änderungen des Kapazitätswertes des Spannungssensors kompensiert.

2. Kondensator (10) nach Anspruch 1, wobei die mindestens eine dielektrische Kompensationsschicht (3b) zwischen der mindestens einen dielektrischen Schicht (3a) und der elektrisch leitenden oder halbleitenden zylindrischen Schale (1) oder dem Schalensegment sandwichartig angeordnet ist.

3. Kondensator (10) nach Anspruch 1 oder 2, wobei die elektrisch leitende oder halbleitende zylindrische Schale (1) oder das Schalensegment eine Ringstruktur bildet, die einen ausgesparten Graben (1b) aufweist, der in seiner Innenwand in Umfangsrichtung verläuft.

4. Kondensator (10) nach Anspruch 3, wobei die mindestens eine dielektrische Kompensationsschicht (3b) eine innerhalb des ausgesparten Grabens (1b) der elektrisch leitenden oder halbleitenden zylindrischen Schale (1) oder des Schalensegments eingebettete Dichtung umfasst.

5. Kondensator (10) nach Anspruch 1, wobei die mindestens eine dielektrische Kompensationsschicht (3b) zwischen der mindestens einen dielektrischen Schicht (3a) und dem elektrisch leitenden Zylinder (2) sandwichartig angeordnet ist.

6. Kondensator (10) nach einem der vorstehenden Ansprüche, wobei die elektrisch leitende oder halbleitende zylindrische Schale (1) oder das Schalensegment einen mechanisch starren Metallbestandteil umfasst, insbesondere einen Aluminium-, Stahl- und/oder Kupferring.

7. Kondensator (10) nach einem der vorstehenden Ansprüche, wobei die mindestens eine dielektrische Schicht (3a) ein Harz, ausgewählt aus Epoxid und Polyurethan, umfasst.

8. Kondensator (10) nach einem der vorstehenden Ansprüche, wobei die mindestens eine dielektrische Schicht (3a) mit hochpermittiven Materialien gefüllt ist, wie zum Beispiel Titanat wie Bariumtitanat oder leitendes Rußpulver, das in dem Polymermaterial dispergiert ist.

9. Kondensator (10) nach einem der vorstehenden Ansprüche, wobei die mindestens eine dielektrische Kompensationsschicht (3b) Kunststoff oder Gummimaterial wie zum Beispiel Silikon, Ethylen-Propylen-Dien-Monomer (EPDM), Ethylen-Propylen-Kautschuk mit hohem Modul (HEPR), Polyethylen (PE) und/oder Polypropylen (PP) umfasst.

10. Kapazitiver Spannungssensor (20), umfassend:
einen Kondensator (10) nach einem der vorstehenden Ansprüche als Spannungserfassungskondensator (CS);
eine Referenzimpedanz (CM), die in Reihe zwischen den Spannungserfassungskondensator (CS) und ein Referenzpotenzial (G) gekoppelt ist; und
eine Spannungsmessschaltung, die konfiguriert ist, um einen Spannungsabfall an der Referenzimpedanz (CM) zu messen.

11. Verfahren (M) zum Herstellen eines Kondensators (10) zur Verwendung in einem Hochspannungs- oder Mittelspannungssensor, umfassend:
einen elektrisch leitenden Zylinder (2), der einen Bestandteil eines Hochspannungs- oder Mittelspannungsstromleiters in einem Hochspannungs- oder Mittelspannungsstromnetz bildet;
eine elektrisch leitende oder halbleitende zylindrischen Schale (1) oder ein Schalensegment, konzentrisch um den elektrisch leitenden Zylinder (2) angeordnet; und ein Dielektrikum (3),
wobei das Dielektrikum (3) Folgendes umfasst:
mindestens eine dielektrische Schicht (3a), die einen positiven thermischen Koeffizienten relativer Permittivität aufweist; und
mindestens eine dielektrische Kompensationsschicht (3b), die einen negativen thermischen Koeffizienten relativer Permittivität aufweist,
wobei die dielektrischen Schichten (3a oder 3b, 6) zwischen dem elektrisch leitenden Zylinder (2) und der elektrisch leitenden oder halbleitenden zylindrischen Schale (1) oder dem Schalensegment angeordnet sind und wobei die mindestens eine dielektrische Kompensationsschicht (3b) so gewählt ist, dass sie jegliche Änderungen der relativen Permittivität der mindestens einen anderen dielektrischen Schicht mit Temperaturen kompensiert und damit jegliche Änderungen des Kapazitätswertes des Spannungssensors kompensiert, umfassend folgende Schritte:
- Aufbringen (M1) eines Dielektrikums (3) auf einen elektrisch leitenden Zylinder (2), der einen Bestandteil eines Hochspannungs- oder Mittelspannungsstromleiters in einem Hochspannungs- oder Mittelspannungsnetz bildet; und
- Anordnen (M2) einer elektrisch leitenden oder halbleitenden zylindrischen Schale (1) oder eines Schalensegments konzentrisch um den elektrisch leitenden Zylinder (2) über dem Dielektrikum (3),
wobei das Dielektrikum (3) mindestens eine dielektrische Schicht (3a), die einen positiven thermischen Koeffizienten relativer Permittivität aufweist, und mindestens eine dielektrische Kompensationsschicht (3b) umfasst, die einen negativen thermischen Koeffizienten relativer Permittivität aufweist.

12. Verfahren (M) nach Anspruch 11, wobei das Aufbringen (M1) des Dielektrikums (3) Folgendes umfasst:
- Formen (M1a) einer dielektrischen Schicht (3a) über dem elektrisch leitenden Zylinder (2); und
- Aufbringen (M1c) einer dielektrischen Kompensationsschicht (3b) über der geformten dielektrischen Schicht.

13. Verfahren (M) nach einem der Ansprüche 11 oder 12, wobei das Anordnen (M2) der elektrisch leitenden oder halbleitenden zylindrischen Schale (1) oder des Schalensegments Folgendes umfasst:
- Aufbringen einer elektrisch leitenden Tinte oder Beschichtung auf die dielektrische Schicht (3a); oder
- Kaltschrumpfverrohren eines elektrisch leitenden Rohrs auf der dielektrischen Schicht (3a).

## Revendications

1. Condensateur (10) pour une utilisation dans un capteur à haute tension ou moyenne tension, comprenant :
un cylindre électriquement conducteur (2) qui fait partie d'un conducteur d'alimentation à haute tension ou moyenne tension dans un réseau électrique à haute tension ou moyenne tension ;
une enveloppe cylindrique électriquement conductrice ou semi-conductrice (1) ou un segment d'enveloppe agencé de manière concentrique autour du cylindre électriquement conducteur (2) ; et
un diélectrique (3),
le diélectrique (3) comprenant :
au moins une couche diélectrique (3a) ayant un coefficient thermique de permittivité relative positif ; et
au moins une couche diélectrique de compensation (3b) ayant un coefficient thermique de permittivité relative négatif,
dans lequel les couches diélectriques (3a ou 3b, 6) sont agencées entre le cylindre électriquement conducteur (2) et l'enveloppe cylindrique électriquement conductrice ou semi-conductrice (1) ou segment d'enveloppe **caractérisé en ce que** ladite au moins une couche diélectrique de compensation (3b) est choisie d'une manière telle qu'elle compense n'importe quels changements de permittivité relative de ladite au moins une autre couche diélectrique avec la température et avec cela, compense n'importe quels changements de valeur de capacité du capteur de tension.

2. Condensateur (10) selon la revendication 1, dans lequel ladite au moins une couche diélectrique de compensation (3b) est intercalée entre ladite au moins une couche diélectrique (3a) et l'enveloppe cylindrique électriquement conductrice ou semi-conductrice (1) ou segment d'enveloppe.

3. Condensateur (10) selon la revendication 1 ou 2, dans lequel l'enveloppe cylindrique électriquement conductrice ou semi-conductrice (1) ou le segment d'enveloppe forme une structure d'anneau ayant une tranchée en retrait (1b) s'étendant de façon circonférentielle dans sa paroi interne.

4. Condensateur (10) selon la revendication 3, dans lequel ladite au moins une couche diélectrique de compensation (3b) comprend un matériau d'étanchéité intégré dans la tranchée en retrait (1b) de l'enveloppe cylindrique électriquement conductrice ou semi-conductrice (1) ou segment d'enveloppe.

5. Condensateur (10) selon la revendication 1, dans lequel ladite au moins une couche diélectrique de compensation (3b) est intercalée entre ladite au moins une couche diélectrique (3a) et le cylindre électriquement conducteur (2).

6. Condensateur (10) selon l'une des revendications précédentes, dans lequel l'enveloppe cylindrique électriquement conductrice ou semi-conductrice (1) ou le segment d'enveloppe comprend un composant métallique mécaniquement rigide, en particulier, un anneau en aluminium, acier et/ou cuivre.

7. Condensateur (10) selon l'une des revendications précédentes, dans lequel ladite au moins une couche diélectrique (3a) comprend une résine, choisie parmi époxy et polyuréthane.

8. Condensateur (10) selon l'une des revendications précédentes, dans lequel ladite au moins une couche diélectrique (3a) est remplie avec des matériaux à permittivité élevée, tels que, par exemple, un titanate tel que le titanate de baryum ou de la poudre de noir de carbone conducteur dispersée dans le matériau polymère.

9. Condensateur (10) selon l'une des revendications précédentes, dans lequel ladite au moins une couche diélectrique de compensation (3b) comprend un matériau de plastique ou de caoutchouc comme, par exemple, de la silicone, un monomère d'éthylène-propylène-diène (EPDM), un caoutchouc d'éthylène-propylène à haut module (HEPR), du polyéthylène (PE) et/ou du polypropylène (PP).

10. Capteur de tension capacitif (20), comprenant :
un condensateur (10) selon l'une des revendications précédentes en tant que condensateur de détection de tension (CS) ;
une impédance de référence (CM) couplée en série entre le condensateur de détection de tension (CS) et un potentiel de référence (G) ; et
un circuit de mesure de tension configuré pour mesurer une chute de tension à travers l'impédance de référence (CM).

11. Procédé (M) pour la fabrication d'un condensateur (10) pour une utilisation dans un capteur de tension à haute tension ou moyenne tension, comprenant :
un cylindre électriquement conducteur (2) qui fait partie d'un conducteur d'alimentation à haute tension ou moyenne tension dans un réseau électrique à haute tension ou moyenne tension ;
une enveloppe cylindrique électriquement conductrice ou semi-conductrice (1) ou un segment d'enveloppe agencé de manière concentrique autour du cylindre électriquement conducteur (2) ; et un diélectrique (3),
le diélectrique (3) comprenant :
au moins une couche diélectrique (3a) ayant un coefficient thermique de permittivité relative positif ; et
au moins une couche diélectrique de compensation (3b) ayant un coefficient thermique de permittivité relative négatif,
dans lequel les couches diélectriques (3a ou 3b, 6) sont agencées entre le cylindre électriquement conducteur (2) et l'enveloppe cylindrique électriquement conductrice ou semi-conductrice (1) ou le segment d'enveloppe et dans lequel ladite au moins une couche diélectrique de compensation (3b) est choisie d'une manière telle qu'elle compense n'importe quels changements de permittivité relative de ladite au moins une autre couche diélectrique avec les températures et avec cela, compense n'importe quels changements de valeur de capacité du capteur de tension, comprenant les étapes consistant à :
- appliquer (M1) un diélectrique (3) à un cylindre électriquement conducteur (2) qui fait partie d'un conducteur d'alimentation à haute tension ou moyenne tension dans un réseau électrique à haute tension ou moyenne tension ; et
- disposer (M2) une enveloppe cylindrique électriquement conductrice ou semi-conductrice (1), ou un segment d'enveloppe, de manière concentrique autour du cylindre électriquement conducteur (2) par-dessus le diélectrique (3),
dans lequel le diélectrique (3) comprend au moins une couche diélectrique (3a) ayant un coefficient thermique de permittivité relative positif et au moins une couche diélectrique de compensation (3b) ayant un coefficient thermique de permittivité relative négatif.

12. Procédé (M) selon la revendication 11, dans lequel l'application (M1) du diélectrique (3) comprend :
- la moulage (M1a) d'une couche diélectrique (3a) par-dessus le cylindre électriquement conducteur (2) ; et
- l'application (M1c) d'une couche diélectrique de compensation (3b) par-dessus la couche diélectrique moulée.

13. Procédé (M) selon l'une des revendications 11 ou12, dans lequel la mise en place (M2) de l'enveloppe cylindrique électriquement conductrice ou semi-conductrice (1) ou du segment d'enveloppe comprend :
- l'application d'une encre ou d'un revêtement électroconducteur sur la couche diélectrique (3a) ; ou
- le tubage par retrait à froid d'un tube électroconducteur sur la couche diélectrique (3a).
